# EUROPEAN PATENT APPLICATION

(11) **EP 3 275 929 A1**
(43) Date of publication of application: **31.01.2018**
(21) Application number: 16768563.5
(22) Date of filing: 15.03.2016
(51) Int. Cl.: C08J 9/30, C08F 2/44, C08F 20/18, H01L 23/373, H05K 7/20

(54) **ACYLIC RESIN HEAT DISSIPATION FOAM SHEET**

(30) Priority: 23.03.2015 JP 2015059216
(71) Applicant: Sekisui Chemical Co., Ltd., Osaka-shi, Osaka 530-8565 (JP)
(72) Inventor: HAMADA, Masahiro, Hasuda-shi Saitama 349-0101 (JP)
(74) Representative: Merkle, Gebhard
(86) International application number: PCT/JP2016/058205
(87) International publication number: WO 2016/152660

(57) **Abstract**

An acrylic resin heat-dissipating foam sheet according to the present invention is a sheet-shaped foam sheet containing an acrylic resin (A), and thermally conductive particles (B) and cells dispersed in the acrylic resin (A), wherein a content of the thermally conductive particles (B) is 100 to 400 parts by mass based on 100 parts by mass of the acrylic resin (A), and the foam sheet further has a 25% compressive strength of 200 kPa or less and a thickness of 0.8 mm or less. The foam sheet of the present invention has the thinness and flexibility sufficient to be suitably used inside electronic equipment and also has excellent thermal conductivity and further excellent insulating properties.

## Description

### Technical Field

The present invention relates to an acrylic resin heat-dissipating foam sheet for efficiently dissipating heat inside electronic equipment to the outside.

### Background Art

In electronic equipment of which miniaturization is required such as a smartphone, electronic components integrated at high density generate a large amount of heat. This heat causes failure of the equipment, and therefore a heat sink material for dissipating this heat outside the equipment is provided. The heat sink material is generally provided between electronic components that are heat-generating bodies and a metal housing. Therefore, as the heat sink material, heat-dissipating greases, heat-dissipating gels, and urethane foams impregnated with these, and the like having high conformability to unevenness are used (for example, PTL1).

On the other hand, an acrylic foam pressure-sensitive adhesive which has low density and in which cells are finely and uniformly dispersed and a method for manufacturing the same are proposed (for example, PTL2).

In addition, a thermally conductive sheet having a first sheet portion in which an electrically conductive filler is contained and a second sheet disposed on the outer periphery of the first sheet portion and having insulating properties, and obtained by integrally-molding these is proposed (for example, PTL3).

PTL1: JP 3976166 B
PTL2: JP 2012-153900 A
PTL3: JP 2014-216339 A

### Summary of Invention

The above heat-dissipating greases have good heat dissipation properties, but their problem is that once the greases are applied, it is difficult to reapply them, and the yields of products decrease. On the other hand, problems of the heat-dissipating gels are that it is generally difficult to process them into the shapes of sheets having a thickness of 1 mm or less, and also that the shapes deform when the heat-dissipating gels are compressed.

In addition, problems of the urethane foams impregnated with heat-dissipating greases, heat-dissipating gels, or the like described above are that it is also difficult to process them into the shapes of sheets having a thickness of 1 mm or less in terms of their manufacturing methods, and also that even if they are processed into thin sheet shapes, the compressive strength increases to thereby lose the flexibility.

In addition, PTL2 discloses that in the acrylic foam pressure-sensitive adhesive, by using a particular stirring apparatus, uniform and fine stable cells can form, but does not teach or suggest an acrylic resin heat-dissipating foam sheet containing thermally conductive particles.

Further, in PTL3, examples of a binder resin for retaining a fibrous filler such as carbon fibers, metal fibers, ceramic fibers, or a nitride in a first thermally conductive sheet include thermoplastic resins, thermoplastic elastomers, and thermosetting resins, but PTL3 does not teach or suggest an acrylic resin heat-dissipating foam sheet.

The present invention has been made in view of the above problems, and it is an object of the present invention to provide an acrylic resin heat-dissipating foam sheet having the thinness and flexibility sufficient to be suitably used inside electronic equipment, having excellent thermal conductivity, and further also having insulating properties.

As a result of diligent studies, the present inventors have found that by containing cells into an acrylic resin having thermally conductive particles to form a foam, flexibility is provided to an acrylic resin sheet together with good thermal conductivity, and that the acrylic resin sheet is useful as a heat sink material for small electronic equipment, thereby completing the present invention. The present invention provides the following (1) to (11).
(1) An acrylic resin heat-dissipating foam sheet, containing an acrylic resin (A), thermally conductive particles (B) and cells dispersed in the acrylic resin (A), wherein
   a content of the thermally conductive particles (B) is 100 to 400 parts by mass based on 100 parts by mass of the acrylic resin (A), and
   the acrylic resin heat-dissipating foam sheet has a 25% compressive strength of 200 kPa or less and a thickness of 0.8 mm or less.
(2) The acrylic resin heat-dissipating foam sheet according to the above (1), having a 50% compressive strength of 350 kPa or less.
(3) The acrylic resin heat-dissipating foam sheet according to the above (1) or (2), wherein the thermally conductive particles (B) have an average particle diameter of 50 µm or less and a thermal conductivity of 8 W/m·K or more.
(4) The acrylic resin heat-dissipating foam sheet according to any of the above (1) to (3), wherein the thermally conductive particles (B) are of at least one selected from the group consisting of aluminum oxide, magnesium oxide, boron nitride, talc, and aluminum nitride having thermal conductivity and being insulators.
(5) The acrylic resin heat-dissipating foam sheet according to any of the above (1) to (4), having a thermal conductivity of 0.1 to 10 W/m·K.
(6) The acrylic resin heat-dissipating foam sheet according to any of the above (1) to (5), having an expansion ratio of 1.5 to 5.
(7) The acrylic resin heat-dissipating foam sheet according to any of the above (1) to (6), wherein the cells are formed by foaming with a physical foaming agent, a gas mixed by a mechanical frothing method, or both of them.
(8) The acrylic resin heat-dissipating foam sheet according to any of the above (1) to (7), wherein the acrylic resin (A) contains a constituent unit derived from an alkyl (meth)acrylate having an alkyl group with from 3 to 12 carbon atoms.
(9) The acrylic resin heat-dissipating foam sheet according to any of the above (1) to (8), wherein the acrylic resin heat-dissipating foam sheet is a thermally conductive foam sheet for electronic equipment.
(10) The acrylic resin heat-dissipating foam sheet according to any of the above (1) to (9), wherein the acrylic resin heat-dissipating foam sheet is a heat sink material.
(11) A method of manufacturing the acrylic resin heat-dissipating foam sheet according to any of the above (1) to (10), containing forming cells in a foam composition containing a curable acrylic resin material and thermally conductive particles (B), and curing the curable acrylic resin material to obtain a foam sheet.

### Description of Embodiments

Embodiments of the present invention will be described in more detail below.

An acrylic resin heat-dissipating foam sheet (hereinafter also simply referred to as a "foam sheet") according to the present invention contains an acrylic resin (A) and thermally conductive particles (B) and cells dispersed in the acrylic resin (A).

### <Acrylic Resin (A)>

The acrylic resin (A) constituting the acrylic resin heat-dissipating foam sheet of the present invention is obtained by polymerizing a monomer containing an acrylate and/or a methacrylate (hereinafter also referred to as a (meth)acrylate).

In the present invention, by using the acrylic resin (A) as a resin constituting the foam sheet, tackiness can be provided to the foam sheet, and the foam sheet can be used as a pressure-sensitive adhesive sheet.

A (meth)acrylate usually has an alkyl group having 12 or less carbon atoms. Specific examples of the (meth)acrylate include n-propyl (meth)acrylate, n-butyl (meth)acrylate, n-amyl (meth)acrylate, n-hexyl (meth)acrylate, 2-ethylhexyl (meth)acrylate, n-octyl (meth)acrylate, isooctyl (meth)acrylate, n-nonyl (meth)acrylate, isononyl (meth)acrylate, and n-decyl (meth)acrylate.

In addition, as another monomer polymerizable with the above acrylate monomer, acrylic acid, methacrylic acid, itaconic acid, vinyl acetate, hydroxyalkyl acrylate, acrylamide, methacrylamide, and the like can be used. When tackiness is provided to the acrylic resin heat-dissipating foam sheet of the present invention, such a monomer is used, for example, in an amount sufficient to provide tackiness to the acrylic resin foam. The amount thereof is generally 30 parts by mass or less per 100 parts by mass of the (meth)acrylate though not limited.

In addition, for monomers constituting the acrylic resin, some amount of a polyfunctional (meth)acrylate such as 1,6-hexanediol diacrylate can be contained. Such a monomer has the effect of providing a crosslinked structure to the acrylic polymer after curing to contribute to the cohesiveness of the foam sheet.

Among these, the acrylic resin (A) preferably contains a constituent unit derived from an alkyl (meth)acrylate having an alkyl group with from 3 to 12 carbon atoms. Preferably 70 to 100% by mass, further preferably 80 to 100% by mass, and particularly preferably 90 to 100% by mass of the above constituent unit derived from an alkyl (meth)acrylate having an alkyl group with from 3 to 12 carbon atoms is contained in the acrylic resin (A).

### < Thermally Conductive Particles (B)>

Examples of the thermally conductive particles (B) include aluminum oxide, magnesium oxide, boron nitride, talc, aluminum nitride, graphite, and graphene. Among these, aluminum oxide, magnesium oxide, boron nitride, talc, and aluminum nitride are preferred. One of these thermally conductive particles (B) may be used alone, or two or more of these thermally conductive particles (B) may be mixed and used.

The thermal conductivity of the thermally conductive particles (B) is preferably 8 W/m·K or more, more preferably 15 W/m·K or more, and further preferably 20 W/m·K or more. When the thermal conductivity is in the above ranges, the thermal conductivity of the foam sheet is sufficiently high. The thermal conductivity of the thermally conductive particles (B) is usually 100 W/m·K or less, although the upper limit thereof is not particularly limited.

The average particle diameter of the thermally conductive particles (B) is preferably 50 µm or less, more preferably 30 µm or less, and further preferably 15 µm or less. When the particle diameter of the thermally conductive particles (B) is in these ranges, the foam is easily made thinner, and a foam sheet having good foamability is obtained. In addition, the average particle diameter of the thermally conductive particles (B) is usually 0.5 µm or more, preferably 1 µm or more, although the lower limit thereof is not particularly limited. The average particle diameter of the thermally conductive particles (B) is a value measured by a particle size distribution meter.

In the foam sheet, the thermally conductive particles (B) are contained in an amount of 100 to 400 parts by mass based on 100 parts by mass of the acrylic resin (A). When the content of the thermally conductive particles (B) is less than 100 parts by mass, sufficient thermal conductivity cannot be provided to the foam sheet. On the other hand, when the content of the thermally conductive particles (B) is more than 400 parts by mass, the flexibility of the foam sheet decreases.

The content of the thermally conductive particles (B) based on 100 parts by mass of the acrylic resin (A) is preferably 150 to 350 parts by mass, more preferably 200 to 300 parts by mass, in view of the thermal conductivity and flexibility of the foam sheet.

### < Cells >

A plurality of cells are contained in the foam sheet of the present invention. The plurality of cells may be formed by foaming with a foaming agent such as a physical foaming agent or formed by a gas mixed by a mechanical frothing method, or it is possible to contain foamed particles, which have been previously foamed, in the foam sheet and utilize the hollow portions inside the foamed particles as cells.

Two or more methods of these may be combined. Specifically, foaming with a physical foaming agent and the mechanical frothing method are preferably combined to form cells. By forming cells by such methods, good foaming with uniform cells is possible.

By containing an infinite number of cells, the foam sheet of the present invention has excellent flexibility while containing the thermally conductive particles (B) and has a 25% compressive strength of 200 kPa or less. When the 25% compressive strength is more than 200 kPa, the flexibility of the foam sheet decreases to cause insufficient conformability to unevenness and the like, and thus performance sufficient as a heat sink material for electronic equipment cannot be exhibited. In view of the flexibility of the foam sheet, the 25% compressive strength of the foam sheet is preferably 20 to 150 kPa, more preferably 25 to 100 kPa.

In addition, the 50% compressive strength of the foam sheet is preferably 350 kPa or less, more preferably 50 to 270 kPa, and further preferably 55 to 180 kPa. When the 25% compressive strength and the 50% compressive strength are in the above ranges, the flexibility of the foam sheet can be improved while the thermal conductivity is increased, and the conformability to unevenness and the like are also good.

In addition, the foam sheet has a thickness of 0.8 mm or less. When the thickness of the foam sheet is more than 0.8 mm, it is difficult to use the foam sheet in a gap inside small electronic equipment. The thickness of the foam sheet is preferably 0.05 to 0.6 mm, more preferably 0.05 to 0.5 mm, in view of the strength and the like of the foam sheet.

In addition, the expansion ratio of the foam sheet is usually about 1.2 to 7 and is preferably 1.5 to 5. By setting the expansion ratio to 5 or less, the thermal conductivity is good, even if the foam sheet is made thin, and thus the foam sheet can be preferably used as a heat sink material. In addition, when the expansion ratio is 1.5 or more, the flexibility is suitable. In view of improving the flexibility and the thermal conductivity with a good balance, the expansion ratio is more preferably 2.0 to 4.0, further preferably 2.5 to 3.5.

Further, the apparent density of the foam sheet is preferably 0.3 to 1.3 g/cm³. When the apparent density is in the above range, a foam sheet having both good flexibility and thermal conductivity though being thin can be obtained. In addition, the apparent density is more preferably 0.3 to 1.2 g/cm³, further preferably 0.5 to 1.0 g/cm³. When the apparent density of the foam sheet is in these ranges, both the flexibility and the thermal conductivity can be improved with a good balance.

The above expansion ratio and apparent density can be appropriately adjusted by changing the amount of the foaming agent used, the amount of the gas mixed by the mechanical frothing method, the content of the foamed particles, which have been previously foamed, or the like.

The thermal conductivity of the foam sheet is preferably 0.1 to 10 W/m·K, more preferably 0.13 to 2.0 W/m·K, and further preferably 0.25 to 2.0 W/m·K. When the thermal conductivity of the foam sheet is in the above ranges, heat inside electronic equipment can be efficiently dissipated to the outside.

In addition, the resistivity of the foam sheet as an indicator of insulating properties is preferably 10¹⁰ (Ω·cm) or more.

### <Polymerization Initiator>

The polymerization of the (meth)acrylate monomer constituting the acrylic resin (A) can be performed by radiation polymerization using ultraviolet rays or the like in the presence of a polymerization initiator. As the polymerization initiator, benzoin alkyl ether, benzophenone, benzyl methyl ketal, hydroxycyclohexyl phenyl ketone, 1,1-dichloroacetophenone, 2-chlorothioxanthone, and the like can be used. Examples of commercial polymerization initiators can include those sold under the trade names of IRGACURE of Ciba Specialty Chemicals, DAROCUR of Merck Japan, and Velsicure of Velsicol Chemical LLC. As for the amount of the polymerization initiator, the polymerization initiator is generally used in an amount of about 0.01 to 5 parts by mass based on 100 parts by mass of the monomer.

However, the polymerization of the acrylic resin (A) is not limited to radiation polymerization and can also be performed by thermal polymerization.

### <Optional Components>

Various other additive components can be contained in the foam sheet as needed, as long as the object of the present invention is not impaired.

The types of these additive components are not particularly limited, and various additives usually used for foaming can be used. Examples of such additives include lubricants, shrinkage inhibitors, cell nucleating agents, crystal nucleating agents, plasticizers, colorants (pigments, dyes, and the like), ultraviolet absorbing agents, antioxidants, anti-aging agents, fillers other than the above thermally conductive particles (B), reinforcing agents, flame retardants, flame-retardant aids, antistatic agents, surfactants, vulcanizing agents, and surface treatment agents. The amounts of the additives added can be appropriately selected as long as that do not impair the formation of cells, and the like, and the amounts added used for usual foaming and molding of a resin can be adopted. Such additives can be used alone, or two or more of such additives can be used in combination. Among these, a lubricant, a flame retardant, and a flame-retardant aid are preferably used.

The lubricant has the function of improving the fluidity of the acrylic resin (A) and suppressing the thermal deterioration of the resin. The lubricant is not particularly limited as long as it has an effect on the improvement of the fluidity of the resin (A). Examples of the lubricant include hydrocarbon-based lubricants such as liquid paraffin, paraffin wax, microwax, and polyethylene wax; fatty acid-based lubricants such as stearic acid, behenic acid, and 12-hydroxystearic acid; and ester-based lubricants such as butyl stearate, stearic acid monoglyceride, pentaerythritol tetrastearate, hydrogenated castor oil, and stearyl stearate.

The amount of the lubricant added is preferably about 0.01 to 5 parts by mass, more preferably 0.05 to 4 parts by mass, and further preferably 0.1 to 3 parts by mass based on 100 parts by mass of the acrylic resin (A). By setting the amount added to 5 parts by mass or less, the expansion ratio is easily made good while the fluidity is made suitable. By setting the amount added to 0.01 parts by mass or more, the fluidity improves to thereby improve the stretchability during foaming, and thus the expansion ratio is easily increased.

Examples of the flame retardant include metal hydroxides such as aluminum hydroxide and magnesium hydroxide, and also bromine-based flame retardants such as decabromodiphenyl ether, and phosphorus-based flame retardants such as ammonium polyphosphate.

Examples of the flame-retardant aid include antimony compounds such as antimony trioxide, antimony tetroxide, antimony pentoxide, sodium pyroantimonate, antimony trichloride, antimony trisulfide, antimony oxychloride, antimony dichloride perchloropentane, and potassium antimonate, boron compounds such as zinc metaborate, zinc tetraborate, zinc borate, and basic zinc borate, zirconium oxides, tin oxides, and molybdenum oxides.

The foam sheet preferably contains a surfactant in order to keep the stability of the cells in the acrylic resin (A) good and promote lower density of the obtained foam sheet. Examples of surfactants that can be used in the present invention include silicone-based surfactants and fluorine-based surfactants.

The amount of the surfactant added is preferably about 0.05 to 5 parts by mass, more preferably 0.1 to 4 parts by mass, and further preferably 0.5 to 3 parts by mass based on 100 parts by mass of the acrylic resin (A). By setting the amount added to 5 parts by mass or less, the stability of the cells is easily kept good. In addition, the effect is exhibited by setting the amount added to 0.05 parts by mass or more.

The foam sheet of the present invention can be used as a thermally conductive foam sheet for electronic equipment.

In addition, the foam sheet of the present invention can be used as a sheet-shaped heat sink material inside electronic equipment. A heat sink material is disposed between a heat-generating body inside electrical equipment and a housing. Here, examples of the heat-generating body include CPUs and batteries.

The foam sheet of the present invention has excellent thermal conductivity while having small thickness, and therefore when it is used as a heat sink material inside electronic equipment, heat generated in a heat-generating body can be efficiently dissipated to the outside. In addition, the foam sheet of the present invention also has excellent flexibility, and therefore it has excellent conformability to unevenness and thus can be disposed even in narrow clearance or the like without creating clearance.

In addition, the foam sheet of the present invention is used as a pressure-sensitive adhesive sheet by virtue of having tackiness. In other words, the foam sheet can be used by adhering it to a housing or other members inside electronic equipment even without separately providing a pressure-sensitive adhesive layer. The foam sheet has tackiness and therefore can also be easily peeled and stuck again or the like even after being stuck once.

The electronic equipment in which the foam sheet of the present invention is used is not particularly limited, but portable equipment such as cellular phones such as smartphones, tablet terminals, electronic paper, notebook PCs, video cameras, and digital cameras is preferred.

### <Method for Manufacturing Foam Sheet>

A method for manufacturing a foam sheet according to the present invention is a method for manufacturing a foam sheet by forming cells in a foam composition containing a curable acrylic resin material and the thermally conductive particles (B), and curing the curable acrylic resin material.

In this manufacturing method, a foam sheet can be manufactured by, for example, forming cells by a mechanical frothing method, forming cells by foaming with a foaming agent, or blending foamed particles, which have been previously foamed, and the manufacturing method is not particularly limited.

Forming cells by a mechanical frothing method will be described below.

First, the curable acrylic resin material is the raw material of the acrylic resin (A) and is specifically obtained by partially polymerizing the monomers constituting the acrylic resin (A).

The (meth)acrylate and the like that are the monomers constituting the acrylic resin (A) have extremely low viscosity. Therefore, for the subsequent stability of cells and facilitating the making of a sheet, predetermined amounts of the thermally conductive particles (B) and optional components blended as needed are blended and uniformly mixed in the presence of a polymerization initiator, and then partial polymerization was performed by radiation polymerization using ultraviolet rays or the like, thereby preparing the so-called syrupy curable acrylic resin material (also referred to as an "acrylic foam precursor composition").

The curable acrylic resin material should have viscosity suitable to form stable cells in the curable acrylic resin material when stirring and mixing the curable acrylic resin material with a gas for forming cells. The curable acrylic resin material preferably has a viscosity of 500 mPa.s or more, particularly 1,000 to 200,000 mPa.s, at operating temperature (for example, 25°C) in a stirring and mixing apparatus. When the viscosity is lower than 500 mPa.s, no cells are formed, and even if cells are formed, they are eliminated by uniting with each other and floating up, and therefore a sufficient amount of cells may not be obtained. Conversely, when the viscosity is higher than 200,000 mPa.s, the flow in a stirring and mixing apparatus is suppressed, and the load on the apparatus may increase too much.

Next, the curable acrylic resin material whose viscosity is adjusted by partial polymerization and a cell-forming gas are introduced into a stirring and mixing apparatus used in the mechanical frothing method, and in this stirring and mixing apparatus, the curable acrylic resin material and the gas for forming cells are stirred and mixed to form cells in the curable acrylic resin material. Then, the foam composition containing these cells is processed into a sheet shape on a base material, and the foam composition processed into a sheet shape is cured, thereby being able to manufacture an acrylic resin heat-dissipating foam sheet. Here, as the gas for forming cells, nitrogen, air, carbon dioxide, argon, and the like can be used. As the stirring and mixing apparatus, Banbury mixers, pressure kneaders, and the like can be used.

When the method of foaming with a foaming agent is used, first, predetermined amounts of the monomers constituting the acrylic resin (A), the thermally conductive particles (B), a foaming agent, and optional components blended as needed are blended and uniformly mixed, and then the monomers constituting the acrylic resin (A) are partially polymerized to form a curable acrylic resin material. Then, the foamable composition containing the curable acrylic resin material, the thermally conductive particles (B), the foaming agent, and the optional components blended as needed is processed into a sheet shape, and cured while being foamed with the foaming agent by heating, thereby being able to manufacture an acrylic resin heat-dissipating foam sheet.

Examples of the foaming agent used include physical foaming agents and chemical foaming agents, and physical foaming agents are preferred. The physical foaming agents generate gases without decomposing the foaming agents. Specific examples of the physical foaming agents include volatile organic solvents.

Examples of the volatile organic solvents include chain or cyclic hydrocarbons such as butane, pentane, hexane, octane, nonane, decane, undecane, cyclopentane, and cyclohexane, ketones such as cyclopentanone, cyclohexanone, and methyl ethyl ketone, esters such as ethyl acetate and butyl acetate, ethers such as tetrahydrofuran, aromatics such as benzene, toluene, xylene, and ethylbenzene, nitrogen-containing compounds such as acetonitrile and N,N-dimethylformamide, and halogen-containing compounds such as methylene chloride, chloroform, and fluorocarbons. These physical foaming agents may be used alone, or two or more of these physical foaming agents may be used in combination. Among these, methyl ethyl ketone is preferably used.

Examples of the chemical foaming agents include thermally decomposable foaming agents, which decompose by heating to result in foaming. The thermally decomposable foaming agents are not particularly limited. Examples of the thermally decomposable foaming agents include azodicarbonamide, N,N'-dinitrosopentamethylenetetramine, and p-toluenesulfonylsemicarbazide. Among these, azodicarbonamide is preferred. One thermally decomposable foaming agent may be used alone, or two or more thermally decomposable foaming agents may be used in combination.

In the method utilizing foamed particles, which have been previously foamed, it is preferred that a foam composition containing a curable acrylic resin material obtained by partially polymerizing the monomers constituting the acrylic resin (A), foamed particles, which have been previously foamed, and optional components added as needed be processed into a sheet shape, and then the curable acrylic resin material be cured by radiation curing to obtain a foam sheet.

As the method for previously foaming foamable particles, it is preferred that part of a curable acrylic resin material and foamable particles be mixed to foam the foamable particles. At this time, the remainder of the curable acrylic resin material and other optional components and the like are further blended into the mixture of the foamed particles, which have been foamed, and the part of the curable acrylic resin material to obtain a foam composition.

The foamable particles used here are preferably thermally expandable microcapsules. In the thermally expandable microcapsules, a volatile substance such as a low boiling point solvent is contained inside an outer shell resin. By heating, the outer shell resin softens, and the contained volatile substance volatilizes or expands. Thus, the outer shells expand due to the pressure, and the particle diameter increases.

The outer shells of the thermally expandable microcapsules are preferably formed of a thermoplastic resin. For the thermoplastic resin, one or two or more selected from the group consisting of vinyl polymers of ethylene, styrene, vinyl acetate, vinyl chloride, vinylidene chloride, acrylonitrile, butadiene, chloroprene, and the like and copolymers thereof; polyamides such as nylon 6 and nylon 66; and polyesters such as polyethylene terephthalate can be used. Copolymers of acrylonitrile are preferred in that the contained volatile substance does not easily pass through them. As the volatile substance contained inside the thermally expandable microcapsules, one or two or more low boiling point liquids selected from the group consisting of hydrocarbons having 3 to 7 carbon atoms such as propane, propylene, butene, normal butane, isobutane, isopentane, neopentane, normal pentane, hexane, and heptane; petroleum ether; halides of methane such as methyl chloride and methylene chloride; chlorofluorocarbons such as CCl₃F and CCl₂F₂; tetraalkylsilanes such as tetramethylsilane and trimethylethylsilane; and the like are used.

Preferred examples of the thermally expandable microcapsules include microcapsules comprising a copolymer of acrylonitrile and vinylidene chloride as an outer shell resin and containing a hydrocarbon having 3 to 7 carbon atoms such as isobutane therein.

Cells may be formed using two or more of the above-described methods in combination, and, for example, cells are preferably formed using in combination the method using a foaming agent and the mechanical frothing method. Also in this case, a volatile organic solvent is preferably used for the foaming agent. Also in this method, first, a curable acrylic resin material obtained by partial polymerization as described above, the thermally conductive particles (B), optional components blended as needed, and a volatile organic solvent are stirred and mixed by a stirring and mixing apparatus while the above-described gas is injected, thereby obtaining a foam composition in which cells are formed. This foam composition is processed into a sheet shape and then heated to foam with the foaming agent to further form cells and cure the curable acrylic resin material to obtain a foam sheet.

In the above manufacturing methods, the foam composition is preferably processed into a sheet shape by being continuously conveyed using calender molding, extruder molding, conveyor belt casting, gravure coating, slot die coating, knife coating, or the like.

As described above, according to the present invention, it is possible to provide an acrylic resin heat-dissipating foam sheet having the thinness and flexibility sufficient to be suitably used inside electronic equipment and having excellent thermal conductivity.

### Examples

The present invention will be described in more detail by Examples, but the present invention is not limited in any way by these examples.

In the present invention, the physical properties and the evaluation methods are as follows.

### [Apparent Density]

The apparent density was measured according to JISK7222.

### [Expansion Ratio]

The expansion ratio was calculated by dividing the specific gravity of a foam composition by the specific gravity of a foam sheet.

### [Thermal Conductivity of Thermally Conductive Particles (B)]

The thermal conductivity of thermally conductive particles (B) was measured by a hot wire method thermal conductivity measuring apparatus TC-1000 manufactured by ULVAC-RIKO, Inc.

### [Average Particle Diameter of Thermally Conductive Particles (B)]

The average particle diameter of the thermally conductive particles (B) was measured by a particle size distribution meter Microtrac HRA by a laser diffraction scattering method.

### [25% Compressive Strength]

The 25% compressive strength of a foam sheet in the thickness direction was measured according to JISK6767-7.2.3 (JIS2009).

### [50% Compressive Strength]

The 50% compressive strength of a foam sheet in the thickness direction was measured according to JISK6767-7.2.3 (JIS2009).

### [Thermal Conductivity of Foam Sheet]

The thermal conductivity was measured at 23°C by a hot disk method using "TPS-1500" manufactured by Kyoto Electronics Manufacturing Co., Ltd.

### [Insulating properties of Foam Sheet]

The thermal resistivity was measured at 23°C by a double ring electrode method using "R-503" manufactured by Kawaguchi Electric Works Co., Ltd.

### [Example 1]

100 Parts by mass of isooctyl acrylate (IOA), 10 parts by mass of acrylic acid, 0.04 part by mass of IRGACURE-651 (2,2-dimethoxy-2-phenylacetophenone, manufactured by Ciba Specialty) as a polymerization initiator, 300 parts by mass of magnesium oxide (RF-10-SC, manufactured by Ube Material Industries, Ltd., average particle diameter: 5 µm, thermal conductivity: 50 W/m·K) as thermally conductive particles, and 3 parts by mass of methyl ethyl ketone as a foaming agent were uniformly mixed at ordinary temperature (23°C) and irradiated with ultraviolet rays having a wavelength of 300 to 400 nm and an intensity of 1 to 3 mW in a nitrogen atmosphere for 5 minutes to partially polymerize IOA. Next, while 100 mL/min of nitrogen gas was injected, the mixture was stirred by a high viscosity fluid stirring apparatus (manufactured by REICA Co., Ltd., product name "VIBRO PQLABO") at a number of revolutions of 500 rpm and a sample flow rate of 2000 mL/min to make a foam composition in which cells were contained.

The obtained foam composition was applied with a thickness of 100 µm to the release-treated surface of a PET sheet having a thickness of 50 µm whose one surface was release-treated. Then, another PET sheet having a thickness of 50 µm whose one surface was release-treated was disposed so that the release-treated surface of the PET sheet was in contact with the applied foam composition, thereby obtaining a laminate. This laminate was irradiated with ultraviolet rays having a wavelength of 300 to 400 nm and an intensity of 0.5 to 7 mW in a nitrogen atmosphere for 4 minutes to perform curing, and then this laminate was heated in an oven at 115°C for 2 minutes. The laminate was removed from the oven, and then the two PET sheets were peeled to obtain a foam sheet having a thickness of 300 µm.

### [Example 2]

Using 100 parts by mass of the same isooctyl acrylate (IOA) as in Example 1, a foam composition in which cells were contained was made as in Example 1 except that 400 parts by mass of magnesium oxide was used.

The obtained foam composition was applied with a thickness of 100 µm to the release-treated surface of a PET sheet having a thickness of 50 µm whose one surface was release-treated. Then, another PET sheet having a thickness of 50 µm whose one surface was release-treated was disposed so that the release-treated surface of the PET sheet was in contact with the applied foam composition, thereby obtaining a laminate. This laminate was irradiated with ultraviolet rays having a wavelength of 300 to 400 nm and an intensity of 0.5 to 7 mW in a nitrogen atmosphere for 4 minutes to perform curing, and then this laminate was heated in an oven at 115°C for 2 minutes. The laminate was removed from the oven, and then the two PET sheets were peeled to obtain a foam sheet having a thickness of 250 µm.

### [Example 3]

A foam composition in which cells were contained was made as in Example 1 except that in Example 1, the amount of methyl ethyl ketone as a foaming agent was increased from 3 parts by mass to 6 parts by mass.

The obtained foam composition was applied with a thickness of 140 µm to the release-treated surface of a PET sheet having a thickness of 50 µm whose one surface was release-treated. Then, another PET sheet having a thickness of 50 µm whose one surface was release-treated was disposed so that the release-treated surface of the PET sheet was in contact with the applied foam composition, thereby obtaining a laminate. This laminate was heated in an oven at 115°C for 2 minutes. The laminate was removed from the oven, and then the two PET sheets were peeled to obtain a thickness of 700 µm foam sheet.

### [Example 4]

A foam sheet having a thickness of 300 µm was obtained as in Example 2 except that in Example 2, the obtained foam composition was applied with a thickness of 100 µm to the release-treated surface of a PET sheet having a thickness of 50 µm whose one surface was release-treated.

### [Example 5]

A foam sheet having a thickness of 300 µm was obtained as in Example 1 except that in Example 1, the thermally conductive particles were changed from 300 parts by mass of magnesium oxide (MgO) to 300 parts by mass of aluminum oxide (Al₂O₃) (AL35-75R, manufactured by NIPPON STEEL & SUMITOMO METAL CORPORATION, average particle diameter: 35 µm, thermal conductivity: 30 W/m·K).

### [Example 6]

A foam sheet having a thickness of 300 µm was obtained as in Example 1 except that in Example 1, the thermally conductive particles were changed from 300 parts by mass of magnesium oxide (MgO) to 300 parts by mass of aluminum nitride (AlN) (ALN300SF, manufactured by Thru Tek, average particle diameter: 30 µm, thermal conductivity: 320 W/m·K).

### [Example 7]

A foam sheet having a thickness of 300 µm was obtained as in Example 1 except that in Example 1, for the thermally conductive particles, 55 parts by mass of boron nitride (BN) (PTX-25S, manufactured by Momentive, average particle diameter: 25 µm, thermal conductivity: 70 W/m·K) was further added to 300 parts by mass of magnesium oxide (MgO).

### [Comparative Example 1]

100 Parts by mass of isooctyl acrylate (IOA), 10 parts by mass of acrylic acid, 0.04 part by mass of IRGACURE-651 (2,2-dimethoxy-2-phenylacetophenone, manufactured by Ciba Specialty), and 300 parts by mass of magnesium oxide (RF-10-SC, manufactured by Ube Material Industries, Ltd., average particle diameter: 5 µm, thermal conductivity: 50 W/m·K) were uniformly mixed and irradiated with ultraviolet rays having a wavelength of 300 to 400 nm and an intensity of 1 to 3 mW in a nitrogen atmosphere for 5 minutes to perform partial polymerization to form a curable acrylic resin material. Next, the above curable acrylic resin material obtained, as a foam composition, was applied with a thickness of 300 µm to the release-treated surface of a PET sheet having a thickness of 50 µm whose one surface was release-treated. Then, another PET sheet having a thickness of 50 µm whose one surface was release-treated was disposed so that the release-treated surface of the PET sheet was in contact with the applied foam composition, thereby obtaining a laminate. This laminate was irradiated with ultraviolet rays having a wavelength of 300 to 400 nm and an intensity of 0.5 to 7 mW in a nitrogen atmosphere for 4 minutes to perform curing, and then this laminate was heated in an oven at 115°C for 2 minutes. The laminate was removed from the oven, and then the two PET sheets were peeled to obtain a non-foaming acrylic resin sheet having a thickness of 300 µm.

### [Comparative Example 2]

100 Parts by mass of isooctyl acrylate (IOA), 10 parts by mass of acrylic acid, 0.04 part by mass of IRGACURE-651 (2,2-dimethoxy-2-phenylacetophenone, manufactured by Ciba Specialty), and 300 parts by mass of magnesium oxide (RF-10-SC, manufactured by Ube Material Industries, Ltd., average particle diameter: 5 µm, thermal conductivity: 50 W/m·K), and 0.8 part by mass of methyl ethyl ketone as a foaming agent were uniformly mixed and irradiated with ultraviolet rays having a wavelength of 300 to 400 nm and an intensity of 1 to 3 mW in a nitrogen atmosphere for 5 minutes to perform partial polymerization to form a curable acrylic resin material. While 40 mL/min of nitrogen gas was injected into the curable acrylic resin material, the curable acrylic resin material was stirred by a high viscosity fluid stirring apparatus (manufactured by REICA Co., Ltd., product name "VIBRO PQLABO") at a number of revolutions of 500 rpm and a sample flow rate of 2000 mL/min to make a foam composition in which cells were contained. Next, the above obtained foam composition in which cells were contained was applied with a thickness of 225 µm to the release-treated surface of a PET sheet having a thickness of 50 µm whose one surface was release-treated. Then, another PET sheet having a thickness of 50 µm whose one surface was release-treated was disposed so that the release-treated surface of the PET sheet was in contact with the applied foam composition, thereby obtaining a laminate. This laminate was irradiated with ultraviolet rays having a wavelength of 300 to 400 nm and an intensity of 0.5 to 7 mW in a nitrogen atmosphere for 4 minutes to perform curing, and then this laminate was heated in an oven at 115°C for 2 minutes. The laminate was removed from the oven, and then the two PET sheets were peeled to obtain a low-foamed acrylic resin sheet having a thickness of 340 µm.

### [Comparative Example 3]

In Comparative Example 2, 1 part by mass of methyl ethyl ketone as a foaming agent was uniformly mixed, and the mixture was irradiated with ultraviolet rays having a wavelength of 300 to 400 nm and an intensity of 1 to 3 mW in a nitrogen atmosphere for 5 minutes to perform partial polymerization to form a curable acrylic resin material. While 50 mL/min of nitrogen gas was injected into the curable acrylic resin material, the curable acrylic resin material was stirred by a high viscosity fluid stirring apparatus (manufactured by REICA Co., Ltd., product name "VIBRO PQLABO") at a number of revolutions of 500 rpm and a sample flow rate of 2000 mL/min to make a foam composition in which cells were contained. Next, the above obtained foam composition in which cells were contained was applied with a thickness of 257 µm to the release-treated surface of a PET sheet having a thickness of 50 µm whose one surface was release-treated. Then, another PET sheet having a thickness of 50 µm whose one surface was release-treated was disposed so that the release-treated surface of the PET sheet was in contact with the applied foam composition, thereby obtaining a laminate. This laminate was irradiated with ultraviolet rays having a wavelength of 300 to 400 nm and an intensity of 0.5 to 7 mW in a nitrogen atmosphere for 4 minutes to perform curing, and then this laminate was heated in an oven at 115°C for 2 minutes. The laminate was removed from the oven, and then the two PET sheets were peeled to obtain a low-foamed acrylic resin sheet having a thickness of 360 µm.

The foam sheets and the acrylic resin sheets obtained in the Examples and the Comparative Examples were evaluated. The results are shown in Table 1.

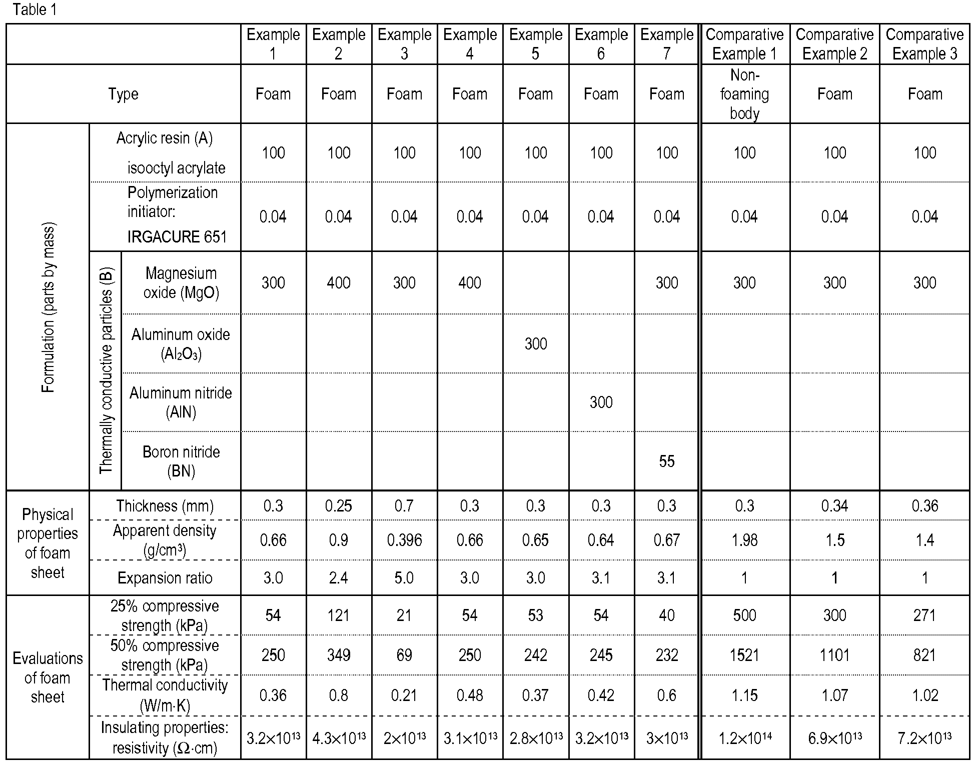

In all, a sufficient resistance value was shown. In the foam sheets of Examples 1 to 7, sufficient cells and thermally conductive particles were contained in the acrylic resin (A), and therefore the foam sheets had thinness and flexibility and had excellent thermal conductivity. Particularly, in Examples 1 and 2 and Examples 4 to 7, in which the expansion ratio was relatively low, the thermal conductivity was sufficiently increased while the compressive strength was made good.

On the other hand, in Comparative Example 1, no cells were contained. Therefore when compression similar to that in Examples 1 to 3 was performed, the compressive strength increased, and flexibility could not be provided. Also in Comparative Examples 2 and 3, the expansion ratio was low, the compressive strength did not decrease, and sufficient flexibility could not be provided.

### Industrial Applicability

The acrylic resin heat-dissipating foam sheet of the present invention can be effectively used as a thermally conductive sheet for electronic equipment such as portable equipment such as cellular phones such as smartphones, tablet terminals, electronic paper, notebook PCs, video cameras, and digital cameras, also as a heat sink material having excellent thermal conductivity, and further as a thermally conductive sheet for electronic equipment or a heat sink material also having insulating properties but is not particularly limited to use in these applications.

## Claims

1. An acrylic resin heat-dissipating foam sheet, comprising: an acrylic resin (A); and thermally conductive particles (B) and cells dispersed in the acrylic resin (A), wherein
a content of the thermally conductive particles (B) is 100 to 400 parts by mass based on 100 parts by mass of the acrylic resin (A), and
the acrylic resin heat-dissipating foam sheet has a 25% compressive strength of 200 kPa or less and a thickness of 0.8 mm or less.

2. The acrylic resin heat-dissipating foam sheet according to claim 1, having a 50% compressive strength of 350 kPa or less.

3. The acrylic resin heat-dissipating foam sheet according to claim 1 or 2, wherein the thermally conductive particles (B) have an average particle diameter of 50 µm or less and a thermal conductivity of 8 W/m·K or more.

4. The acrylic resin heat-dissipating foam sheet according to any one of claims 1 to 3, wherein the thermally conductive particles (B) are at least one selected from the group consisting of aluminum oxide, magnesium oxide, boron nitride, talc, and aluminum nitride, having thermal conductivity and being insulators.

5. The acrylic resin heat-dissipating foam sheet according to any one of claims 1 to 4, having a thermal conductivity of 0.1 to 10 W/m·K.

6. The acrylic resin heat-dissipating foam sheet according to any one of claims 1 to 5, having an expansion ratio of 1.5 to 5.

7. The acrylic resin heat-dissipating foam sheet according to any one of claims 1 to 6, wherein the cells are formed by foaming with a physical foaming agent, a gas mixed by a mechanical frothing method, or both of them.

8. The acrylic resin heat-dissipating foam sheet according to any one of claims 1 to 7, wherein the acrylic resin (A) comprises a constituent unit derived from an alkyl (meth)acrylate having an alkyl group with from 3 to 12 carbon atoms.

9. The acrylic resin heat-dissipating foam sheet according to any one of claims 1 to 8, wherein the acrylic resin heat-dissipating foam sheet is a thermally conductive foam sheet for electronic equipment.

10. The acrylic resin heat-dissipating foam sheet according to any one of claims 1 to 9, wherein the acrylic resin heat-dissipating foam sheet is a heat sink material.

11. A method of manufacturing the acrylic resin heat-dissipating foam sheet according to any one of claims 1 to 10, comprising:
forming cells in a foam composition comprising a curable acrylic resin material and thermally conductive particles (B); and curing the curable acrylic resin material to obtain an acrylic resin heat-dissipating foam sheet.
